# EUROPÄISCHE PATENTANMELDUNG

(11) **EP 4 590 081 A1**
(43) Veröffentlichungstag der Anmeldung: **23.07.2025**
(21) Anmeldenummer: 24153153.2
(22) Anmeldetag: 22.01.2024
(51) Int. Cl.: H05K 7/14

(54) **LEITERPLATTENGEHÄUSE**

(71) Anmelder: Hilti Aktiengesellschaft, 9494 Schaan (LI)
(72) Erfinder: Zimmerer, Claudia, 88131 Lindau (DE); Schlichting, Daniel, 86833 Ettringen (DE)
(74) Vertreter: Hilti Aktiengesellschaft Corporate Intellectual Property

(57) **Zusammenfassung**

Leiterplattengehäuse mit einer darin angeordneten Leiterplatte, wobei die Leiterplatte einen Schraubverbinder zum Verbinden eines elektrischen Leiters mit der Leiterplatte auf einer Anschlussseite der Leiterplatte aufweist, wobei der Schraubverbinder in einem Einbettungsbereich formschlüssig in das Leiterplattengehäuse eingebettet ist, so dass ein auf den Schraubverbinder wirkendes Anschraubmoment in das Leiterplattengehäuse eingeleitet wird.

## Beschreibung

Die vorliegende Erfindung betrifft ein Leiterplattengehäuse mit einer darin angeordneten Leiterplatte, wobei die Leiterplatte einen Schraubverbinder zum Verbinden eines elektrischen Leiters mit der Leiterplatte auf einer Anschlussseite der Leiterplatte aufweist.

Elektrischen Kontaktieren mittels Verschraubungen ist grundsätzlich aus dem Stand der Technik bekannt. EP 2 849 549 A1 offenbart eine Leiterplatte, die mittels einer Schraube an einem Kühlkörper montiert ist. Dabei steht die Schraube mit einer Masseebene der Leiterplatte elektrisch in Kontakt. DE 10 2020 102 219 A1 zeigt einen Kraftfahrzeug-Ladestecker mit einer Leiterplatte, in die ein galvanisch mit der Leiterplatte gekoppelter Gewindebolzen integriert ist.

Es ist Aufgabe der vorliegenden Erfindung ein Leiterplattengehäuse mit einer darin angeordneten Leiterplatte anzugeben, das die Grundlage ein schonendes Verbinden eines elektrischen Leiters bietet.

Die Aufgabe wird dadurch gelöst, dass der Schraubverbinder in einem Einbettungsbereich formschlüssig in das Leiterplattengehäuse eingebettet ist, so dass ein auf den Schraubverbinder wirkendes Anschraubmoment vorzugsweise vollständig in das Leiterplattengehäuse eingeleitet wird. Ein Anschraubmoment kann beispielsweise entstehen, wenn ein mit einem ringförmigen Kabelschuh ausgestatteter elektrische Leiter auf den Schraubverbinder gefädelt und durch Aufschrauben einer Mutter befestigt wird.

Die Erfindung schließt die Erkenntnis ein, dass bei Leiterplatten mit Schraubverbindem des Standes der Technik ein Anschraubmoment in die Leiterplatte eingebracht wird und dadurch Kupferbahnen oder elektrische Bauteile beschädigt werden können. Dadurch, dass der erfindungsgemäße Schraubverbinder im Einbettungsbereich formschlüssig in das Leiterplattengehäuse eingebettet ist, wird dieser Nachteil vermieden.

In einer besonders bevorzugten Ausgestaltung weist die Leiterplatte eine Durchgangsbohrung auf durch welche der Schraubverbinder berührungsfrei hindurchragt. Dadurch wird, zumindest unmittelbar, kein auf den Schraubverbinder wirkendes Anschraubmoment in die Leiterplatte eingebracht.

Es hat sich als vorteilhaft herausgestellt, wenn das Leiterplattengehäuse eine vom Schraubverbinder verschiedene, elektrisch leitfähige Zylinderbuchse aufweist, die koaxial zum

Schraubverbinder angeordnet ist. In einer weiteren bevorzugten Ausgestaltung erstreckt sich der Schraubverbinder vollständig durch die Zylinderbuchse hindurch. Es hat sich als vorteilhaft herausgestellt, wenn die Zylinderbuchse abgestuft ist. Es kann vorgesehen sein, dass zwischen Leiterplatte und Schraubverbinder kein unmittelbarer elektrischer Kontakt besteht.

In einer weiteren bevorzugten Ausgestaltung ist die Zylinderbuchse mit der Leiterplatte verlötet und/oder elektrisch mit einer Leiterbahn der Leiterplatte verbunden. Es hat sich als vorteilhaft herausgestellt, wenn die Zylinderbuchse zum Schraubverbinder eine Spielpassung aufweist. Die Zylinderbuchse kann in die Durchgangsbohrung der Leiterplatte eingesteckt sein.

In einer weiteren bevorzugten Ausgestaltung befindet sich der Einbettungsbereich des Schraubverbinders vollständig auf einer der Anschlussseite abgewandten Seite der Leiterplatte. Es hat sich weiterhin als vorteilhaft herausgestellt, wenn die Leiterplatte, in axialer Richtung des Schraubverbinders, auf dem Einbettungsbereich abgestützt ist. Somit kann ein Durchbiegen der Leiterplatte beim Aufbringen eines Anschraubmoments verhindert werden.

In einer besonders bevorzugten Ausgestaltung ist der Schraubverbinder als Stange ausgebildet, die zumindest abschnittsweise ein Außengewinde aufweist. Der Schraubverbinder kann eine Sechskantschraube, beispielsweise nach DIN 933 sein. Alternativ kann der Schraubverbinder als Hülse ausgebildet sein, die zumindest abschnittsweise ein Innengewinde aufweist. Es hat sich als vorteilhaft herausgestellt, wenn mehrere Schraubverbinder vorgesehen sind. In einer besonders bevorzugten Ausgestaltung weist die Leiterplatte genau 3 Schraubverbinder auf. In einer weiteren bevorzugten Ausgestaltung ist die Leiterplatte vollständig vergossen. Es hat sich als vorteilhaft herausgestellt, wenn die Zylinderbuchse eine Vergussebene abschnittsweise überragt.

Weitere Vorteile ergeben sich aus der folgenden Figurenbeschreibung. In den Figuren ist ein besonders bevorzugtes Ausführungsbeispiele der vorliegenden Erfindung dargestellt. Die

Figuren, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

In der Figur sind gleiche und gleichartige Komponenten mit gleichen Bezugszeichen beziffert. Es zeigt:
- Figur 1: ein bevorzugtes Ausführungsbeispiel eines Leiterplattengehäuses;
- Figur 2: eine perspektivische Darstellung des Ausführungsbeispiels der Figur 1; und
- Figur 3: das Ausführungsbeispiel der Figur 1 und 2 ohne Leiterplatte.

### Ausführungsbeispiel:

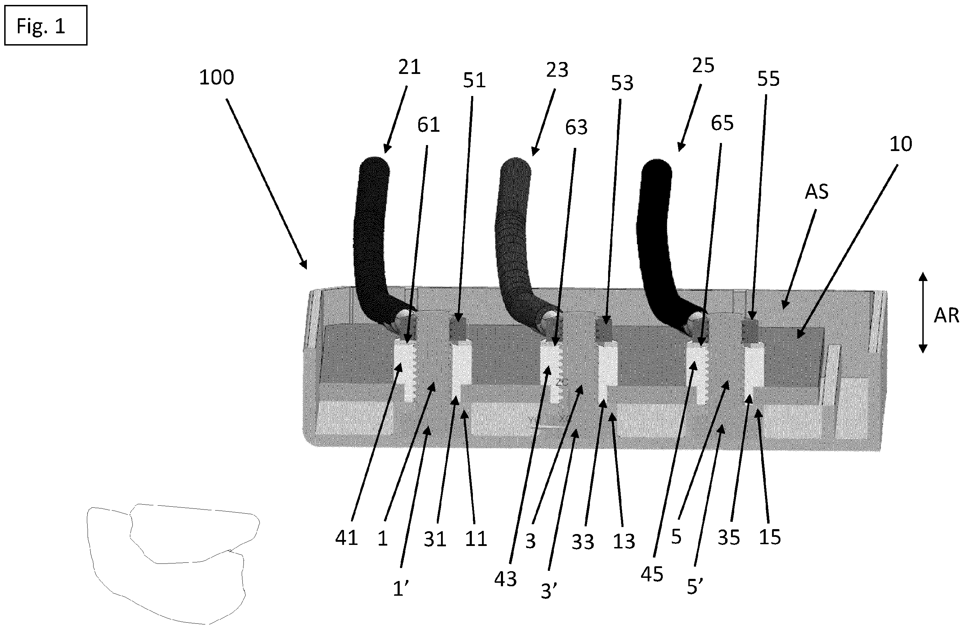

Ein bevorzugtes Ausführungsbeispiel eines erfindungsgemäßen Leiterplattengehäuses 100 in Schnittdarstellung ist in Figur 1 dargestellt. Das Leiterplattengehäuse 100 ist ausgestattet mit einer darin angeordneten Leiterplatte 10. Die Leiterplatte 10 verfügt über drei Schraubverbinder 1, 3, 5 zum Verbinden jeweils eines elektrischen Leiters 21, 23, 25 mit der Leiterplatte 10 auf einer Anschlussseite AS der Leiterplatte 10.

Der elektrische Leiter 21, 23, 25 kann beispielsweise durch eine biegsame Litze, ein Blech oder eine Kupferschiene ausgestaltet sein. In den Figuren ist der elektrische Leiter 21, 23, 25 in Form einer biegsamen Litze ausgestaltet.

Im vorliegend dargestellten Ausführungsbeispiel sind die Schraubverbinder 1, 3, 5 als Stangen ausgebildet, die jeweils ein Außengewinde aufweisen. Die im Wesentlichen zylinderförmigen Schraubverbinder 1, 3, 5 sind in einem Einbettungsbereich 11, 13, 15 formschlüssig in das Leiterplattengehäuse 100 eingebettet. Die Formschlüssigkeit wird beispielhaft dadurch erreicht, dass ein formschlüssiger Bereich 1', 3', 5' eines jeweiligen Schraubverbinders 1, 3, 5, in das aus Kunststoff gefertigte Leiterplattengehäuse 100 eingegossen ist. Somit wird ein auf den Schraubverbinder 1, 3, 5 wirkendes Anschraubmoment in das Leiterplattengehäuse 100 eingeleitet. Im Falle der Bereitstellung eines Schraubverbinders als Sechskantschraube, wäre der Kopf der Sechskantschraube der formschlüssig wirkende Bereich. Die Einbettungsbereiche 11, 13, 15 sind jeweils vollständig auf einer der Anschlussseite AS abgewandten Seite der Leiterplatte 10 befindlich.

Wie der Figur 1 entnommen werden kann, weist die Leiterplatte 100 drei Durchgangsbohrungen 31, 33, 35 auf, durch welche die Schraubverbinder 1, 3, 5 jeweils berührungsfrei (bezogen auf die Leiterplatte 100) hindurchragen. Somit besteht kein unmittelbarer elektrischer Kontakt zwischen der Leiterplatte 100 und den Schraubverbindern 1, 3, 5. Das Leiterplattengehäuse 100 weist drei vom Schraubverbinder 1, 3, 5 verschiedene, elektrisch leitfähige Zylinderbuchsen 41, 43, 45 auf, die jeweils koaxial zum Schraubverbinder 1, 3, 5 angeordnet sind. Die Zylinderbuchsen 41, 43, 45 sind abgestuft ausgebildet und in die drei Durchgangsbohrungen 31, 33, 35 eingesteckt. Weiterhin sind die Zylinderbuchsen 41, 43, 45 mit der Leiterplatte 10, genauer gesagt mit einer hier nicht dargestellten Leiterbahn der Leiterplatte 10, verlötet. Die Zylinderbuchsen 41, 43, 45 weisen zum Schraubverbinder 1, 3, 5 jeweils eine Spielpassung auf, so dass auch in die Zylinderbuchsen 41, 43, 45 kein am Schraubverbinder 1, 3, 5 wirkendes Anschraubmoment in die Leiterplatte 10 eingetragen wird.

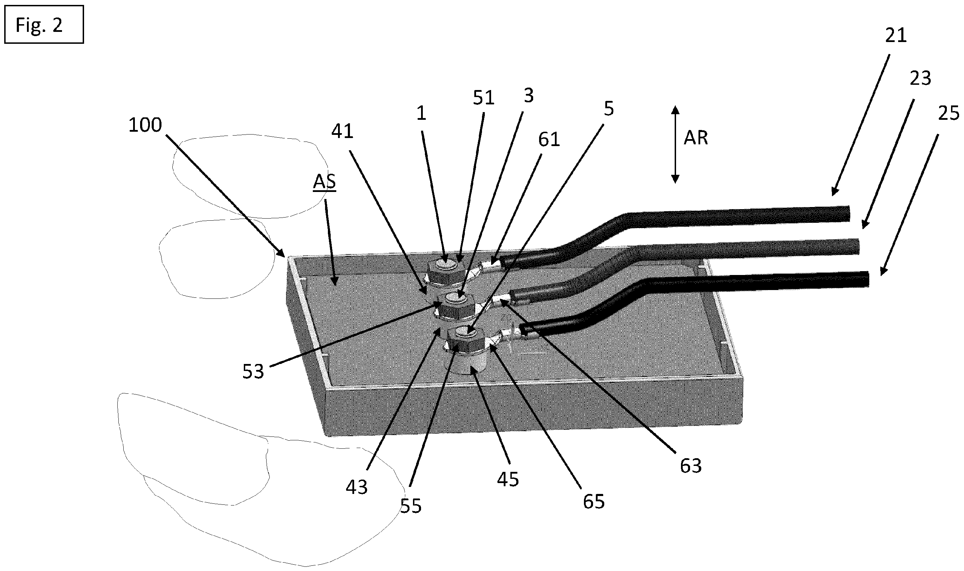

Wie der Figur 1 ebenfalls entnommen werden kann, sind die elektrischen Leiter 21, 23, 25 jeweils mit einem Kabelschuh 61, 63, 65 ausgestattet (vgl. auch Figur 2). Die ringförmigen Kabelschuhe 61, 63, 65 sind jeweils auf die als Stange mit Außengewinde ausgebildeten Schraubverbinder 1, 3, 5 aufgefädelt und jeweils mittels einer Mutter 51, 53, 55 gesichert.

Eine elektrische Verbindung zwischen den Kabelschuhen 61, 63, 65 und der Leiterplatte ist dadurch gegeben, dass die Kabelschuhe 61, 63, 65 auf den elektrisch leitfähigen Zylinderbuchsen 41, 43, 45 aufliegen und die Zylinderbuchsen 41, 43, 45 wiederum elektrisch leitfähig mit der Leiterplatte 10 verlötet sind.

Zur weiteren Entlastung der Leiterplatte 10, ist diese in axialer Richtung AR des Schraubverbinders 1, 3, 5, auf den Einbettungsbereichen 11, 13, 15 abgestützt. Die in axialer Richtung AR wirkende Spannkraft der Muttern 51, 53, 55 wird über die Kabelschuhe 61, 63, 65 auf die Zylinderbuchsen 41, 43, 45 von dort über die Leiterplatte 10 in die Einbettungsbereiche 11, 13, 15 eingeleitet, ohne dass es zu einer Verbiegung der Leiterplatte kommen kann.

Figur 2 zeigt eine perspektivische Darstellung des Ausführungsbeispiels der Figur 1. Gut zu erkennen ist, dass die ringförmigen Kabelschuhe 61, 63, 65 jeweils auf die als Stange mit Außengewinde ausgebildeten Schraubverbinder 1, 3, 5 aufgefädelt und jeweils mittels der Mutter 51, 53, 55 gesichert sind. Dabei liegen die Kabelschuhe 61, 63, 65 jeweils auf Zylinderbuchsen 41, 43, 45 auf. Die Zylinderbuchsen 41, 43, 45 überragen die Leiterplatte 10 in axialer Richtung AR. Somit kann die Leiterplatte 10, die ist in Figur 2 nicht gezeigt, vollständig innerhalb des Leiterplattengehäuse vergossen sein. Durch die Wahl einer geeigneten Bauteilhöhe der Zylinderbuchsen 41, 43, 45 kann die Schraubverbindungsstelle flexibel gestaltet werden, so dass sie idealerweise oberhalb des Vergussniveaus zum Liegen kommt und damit eine lösbare Verbindung realisiert werden kann.

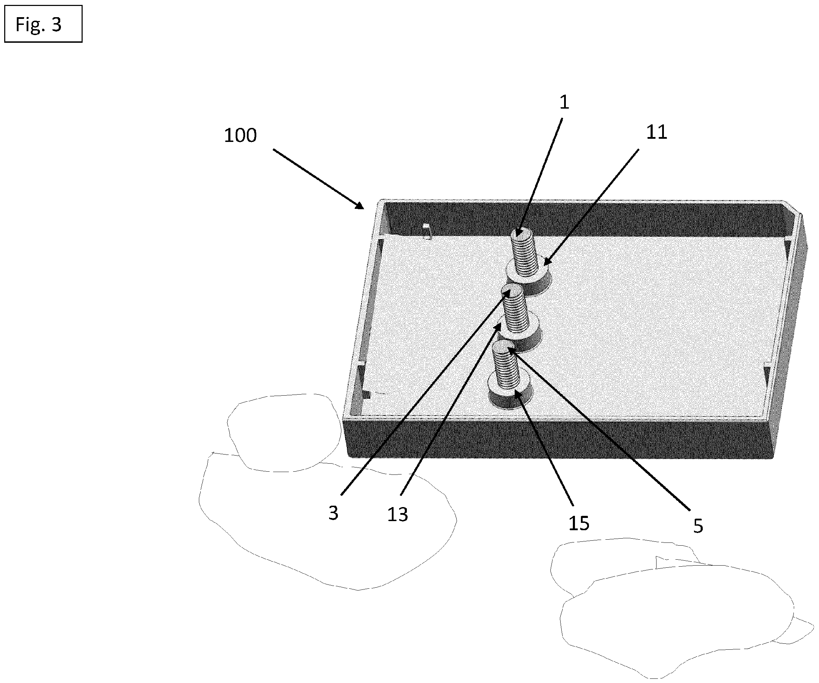

Figur 3 zeigt schließlich das Ausführungsbeispiel der Figur 1 und Figur 2 ohne Leiterplatte 10. Gut zu erkennen ist, wie die stangenförmig mit Außengewinde ausgebildeten Schraubverbinder 1, 3, 5 im Einbettungsbereich 11, 13, 15 eingebettet sind. Die Einbettungsbereiche 11, 13, 15 sind einstückig mit dem Leiterplattengehäuse 100 ausgebildet und bestehen aus Kunststoff. Auf einem jeweiligen freien ringförmigen Bereich der Einbettungsbereiche 11, 13, 15 ist die hier nicht dargestellte Leiterplatte 10 abgestützt.

### Bezugszeichenliste

- 1, 3, 5: Schraubverbinder
- 1', 3', 5: formschlüssiger Bereich des Schraubverbinders
- 10: Leiterplatte
- 11, 13, 15: Einbettungsbereich
- 21, 23, 25: elektrischer Leiter
- 31, 33, 35: Durchgangsbohrung
- 41, 43, 45: Zylinderbuchse
- 51,53,55: Mutter
- 61, 63, 65: Kabelschuh
- 100: Leiterplattengehäuse
- 21, 23, 25: elektrischer Leiter

- AR: axiale Richtung
- AS: Anschlussseite der Leiterplatte

## Patentansprüche

1. Leiterplattengehäuse (100) mit einer darin angeordneten Leiterplatte (10), wobei die Leiterplatte (10) einen Schraubverbinder (1, 3, 5) zum Verbinden eines elektrischen Leiters (21, 23, 25) mit der Leiterplatte (10) auf einer Anschlussseite (AS) der Leiterplatte (10) aufweist,
**dadurch gekennzeichnet, dass** der Schraubverbinder (1, 3, 5) in einem Einbettungsbereich (11, 13, 15) formschlüssig in das Leiterplattengehäuse (100) eingebettet ist, so dass ein auf den Schraubverbinder (1, 3, 5,) wirkendes Anschraubmoment in das Leiterplattengehäuse (100) eingeleitet wird.

2. Leiterplattengehäuse (100) nach Anspruch 1,
**dadurch gekennzeichnet, dass** die Leiterplatte (100) eine Durchgangsbohrung (31, 33, 35) aufweist durch welche der Schraubverbinder (1, 3, 5) berührungsfrei hindurchragt.

3. Leiterplattengehäuse (100) nach Anspruch 1 oder 2,
**dadurch gekennzeichnet, dass** das Leiterplattengehäuse (100) eine vom Schraubverbinder (1, 3, 5) verschiedene, elektrisch leitfähige Zylinderbuchse (41, 43, 45) aufweist, die koaxial zum Schraubverbinder (1, 3, 5) angeordnet ist.

4. Leiterplattengehäuse (100) nach Anspruch 3,
**dadurch gekennzeichnet, dass** die Zylinderbuchse (41, 43, 45) mit der Leiterplatte verlötet ist und zum Schraubverbinder (1, 3, 5) eine Spielpassung aufweist.

5. Leiterplattengehäuse (100) nach einem der vorangehenden Ansprüche,
**dadurch gekennzeichnet, dass** sich der Einbettungsbereich (11, 13, 15) vollständig auf einer der Anschlussseite (AS) abgewandten Seite der Leiterplatte (10) befindet.

6. Leiterplattengehäuse (100) nach einem der vorangehenden Ansprüche,
**dadurch gekennzeichnet, dass** die Leiterplatte (10), in axialer Richtung (AR) des Schraubverbinders (1, 3, 5), auf dem Einbettungsbereich (11, 13, 15) abgestützt ist.

7. Leiterplattengehäuse (100) nach einem der vorangehenden Ansprüche,
**dadurch gekennzeichnet, dass** der Schraubverbinder (1, 3, 5) als Stange ausgebildet ist, die zumindest abschnittsweise ein Außengewinde aufweist.

8. Leiterplattengehäuse (100) nach einem Ansprüche 1 bis 7,
**dadurch gekennzeichnet, dass** der Schraubverbinder (1, 3, 5) als Hülse ausgebildet ist, die zumindest abschnittsweise ein Innengewinde aufweist.

9. Leiterplattengehäuse (100) nach einem der vorangehenden Ansprüche,
**dadurch gekennzeichnet, dass** mehrere Schraubverbinder (1, 3, 5) vorgesehen sind.

10. Leiterplattengehäuse (100) nach einem der vorangehenden Ansprüche,
**dadurch gekennzeichnet, dass** die Leiterplatte (10) vollständig vergossen ist.
